# EUROPEAN PATENT APPLICATION

(11) **EP 2 731 134 A1**
(43) Date of publication of application: **14.05.2014**
(21) Application number: 13184054.8
(22) Date of filing: 12.09.2013
(51) Int. Cl.: H01L 25/065, H05K 7/02, H01L 23/538, H01L 23/00

(54) **Multi-chip module connection by way of bridging blocks**

(30) Priority: 13.11.2012 US 201213675184
(71) Applicant: LSI Corporation, Milpitas, CA 95035 (US)
(72) Inventor: Hawk, Donald E., Allentown, PA Pennsylvania 18109 (US); Osenbach, John W., Allentown, PA Pennsylvania 18109 (US); Parker, James C., Allentown, PA Pennsylvania 18109 (US)
(74) Representative: Williams, David John

(57) **Abstract**

One aspect provides an integrated circuit (IC) multi-chip packaging assembly, comprising a first IC chip having packaging substrate contacts and bridging block contacts, a second IC chip having packaging substrate contacts and bridging block contacts, and a bridging block partially overlapping the first and second IC chips and having interconnected electrical contacts on opposing ends thereof that contact the bridging block contacts of the first IC chip and the second IC chip to thereby electrically connect the first IC chip to the second chip.

## Description

### TECHNICAL FIELD

This application is directed to a multi-chip stacking of integrated devices using partial device overlap.

### BACKGROUND

Packaging of multiple semiconductor chips in 2.5D (2.5 dimensional) and 3D (3 dimensional) packages is the latest trend in the semiconductor industry. Current conventional embodiments employ either silicon interposers in a side by side configuration, termed 2.5D, or by vertical stacking of die with thru-silicon vias (TSV) to achieve true 3D devices, and in many cases both types of technologies are used. TSV is an important developing technology that utilizes short, vertical electrical connections or "vias" that pass directly through a silicon wafer in order to establish an electrical connection from the active side to the backside of the die, thus providing the shortest interconnect path and creating an avenue for the ultimate in 3D integration. A silicon interposer is typically a wide silicon layer on which multiple chips are surface mounted, either vertically or horizontally, and most often employs TSV to make connections from the package substrate to the chips bonded thereto. The use of silicon interposers and TSV offer greater space efficiencies and higher interconnect densities than wire bonding and general flip chip technology. The combination of these technologies enables a higher level of functional integration and performance in a smaller form factor in that their presence allows a manufacturer to stack vertically IC devices and pass electrical signals and power and ground up and down the through the stack.

### SUMMARY

One aspect provides an integrated circuit (IC) multi-chip packaging assembly, comprising a first IC chip having packaging substrate contacts and bridging block contacts, a second IC chip having packaging substrate contacts and bridging block contacts. This embodiment further comprises a bridging block that partially overlaps the first and second IC chips and has interconnected electrical contacts on opposing ends thereof that contact the bridging block contacts of the first IC chip and the second IC chip, to thereby electrically connect the first IC chip to the second chip.

Another embodiment provides an integrated circuit (IC) multi-chip packaging assembly, comprising first and second sub-packaging assemblies. The first sub-packaging assembly comprises a first IC chip having packaging substrate contacts and bridging block contacts, and a second IC chip having packaging substrate contacts and bridging block contacts. This embodiment further comprises a bridging block that partially overlaps the first and second IC chips and has interconnected electrical contacts on opposing ends thereof that contact the bridging block contacts of the first IC chip and the second IC chip, to thereby electrically connect the first IC chip to the second chip. The second sub-packaging assembly comprises a second substrate having bond pads wherein the packaging substrate contacts of the first and second IC chips are connected to the bond pads of the second sub-packaging assembly by bonding contacts. The bridging block has a thickness that is less than a thickness of the bonding contacts and is located between the first and second sub-packaging assemblies.

Yet another embodiment provides a method of manufacturing an integrated circuit (IC) multi-chip packaging assembly. In this embodiment, the method comprises obtaining a first IC chip having packaging substrate contacts and bridging block contacts, obtaining a second IC chip having packaging substrate contacts and bridging block contacts, and obtaining a bridging block comprising interconnected first electrical contacts located on one end thereof and second electrical contacts located on opposing, second end thereof. The first electrical contacts of the bridging block are bonded to the bridging block contacts of the first IC chip, and the second electrical contacts of the bridging block are bonded to the bridging block contacts of the second IC chip.

### BRIEF DESCRIPTION

Reference is now made to the following descriptions taken in conjunction with the accompanying drawings, in which:
FIG. 1 illustrates an embodiment of a IC packaging assembly;
FIG. 2 illustrates an embodiment of a bridging block used in the IC packaging assembly of FIG. 1;
FIG. 3 illustrates another embodiment of the IC packaging assembly of FIG. 1 that includes using multiple bridging blocks;
FIG. 4 illustrates another embodiment of an IC packaging assembly multiple IC chips bridged by a bridging block; and
FIG. 5 illustrates another embodiment of the IC packaging assembly of FIG. 1 bonded to a second IC packaging assembly.

### DETAILED DESCRIPTION

The present disclosure is directed to a packaging assembly that utilizes a thin bridging block to electrically connect two or more IC chips together to form a multi-chip sub-packaging assembly, which then can be bonded to a base packaging substrate, which in turn can then be bonded to a printed circuit board. This configuration allows direct face-to-face chip attachment that eliminates the need for silicon interposers and TSV to achieve more compact device integration. This is a significant manufacturing advantage over present processes, because silicon interposers and TSV introduce complex manufacturing processes and cost adders. Further, the stacking of the die that is associated with 3D technologies can impose power and thermal restrictions. Additionally these silicon interposer structures can introduce signal delay beyond which is tolerable for certain applications. The use of TSV also has implications on layout configurations. The present disclosure eliminates the need for silicon interposers and TSV, while achieving similar levels of integration but avoiding the above-mentioned problems.

The partial overlap of the devices present in the embodiments discussed herein provides the advantage of exposing a portion of one or more devices to a standard package-like configuration and allows for the use of conventional package interconnects. Additionally, the use of a thin connecting bridging block allows multiple IC devices to be interconnected without the need for a silicon interposer or TSV, and allows for high speed interconnects to the package, which are well characterized. The embodiments covered by this disclosure also move the die-to-die connections to an edge placement so as not to interfere with standard core floor plan arrangements. The on edge placement also allows for more of the IC device to be exposed, thereby providing greater surface area for more direct connectivity. These die-to-die interconnects can be done without long redistribution routes, thereby reducing delay concerns. A brief list of Examples of devices in which the various embodiments presented by this disclosure may be used include baseband (DSP), applications, processors, power management, RF transceiver, or memory for wireless mobile or digital consumer product applications, where the I/O counts are higher, for example up around 750.

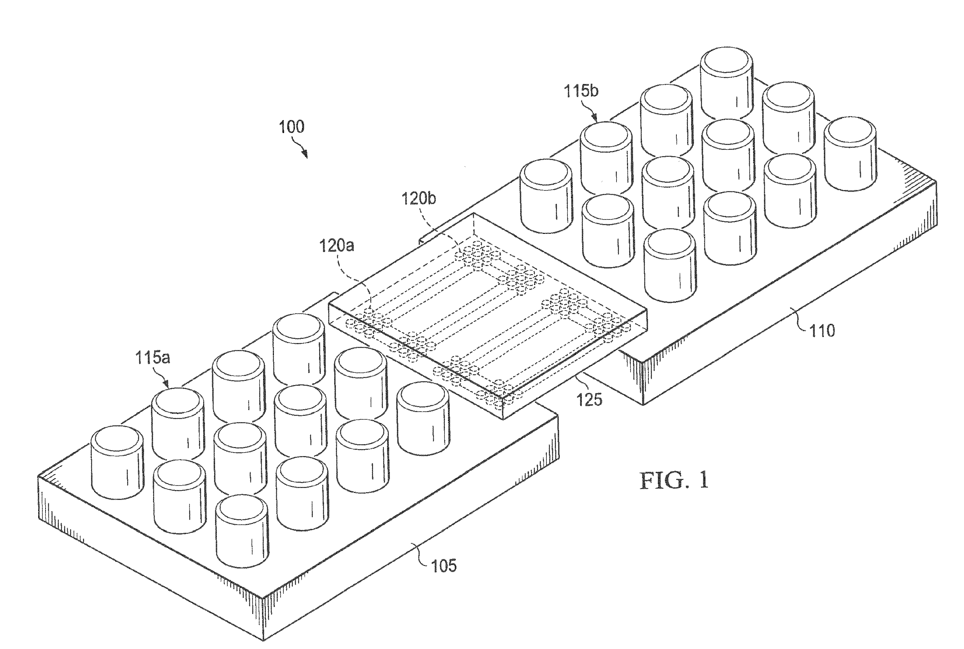

FIG. 1 illustrates one embodiment of an IC packaging sub-assembly 100, as provided by this disclosure. This embodiment comprises at least two IC chips 105 and 110. IC chips 105 and 110 may be memory chips, processor chips, or other similar active devices. Other embodiments, as discussed below, provide a configuration that includes more than two of the IC chips 105, 110. Neither IC chip 105 nor 110 need employ the above-discussed interposers nor TSV as means of interconnect. As used herein and in the claims, a TSV is a vertical electrical connection or "via" passing from the active device side of silicon wafer to the backside of the silicon wafer. The embodiments provided by this disclosure are counter-intuitive to present practices that vertically stack devices directly over one another using silicon interposers and TSV technology.

The IC chips 105, 110 have packaging substrate contacts 115a, 115b and bridging block contacts 120a, 120b, respectively. As used herein and in the claims, the word "contacts" may be an array of bond pads, copper pillars, or they may be an array of solder bumps having been placed on bond pads. The illustrations discussed herein show embodiments that are either copper pillars or solder bumps formed on bond pads. However, it should be understood that other similar bonding technologies may be used. In one embodiment, the bridging block contacts 120a, 120b are high density contacts. As used herein and in the claims, high density contacts are contacts that have at least about 100 contacts/mm². In another embodiment, the bridging block contacts 120a, 120b have a fine pitch that ranges from about 40 microns to about 50 microns as measured from the center points of adjacent contacts.

A bridging block 125 partially overlaps the IC chips 105, 110 and electrically connects IC chip 105 to IC chip 110 adjacent the edges of IC chips 105, 110. The bridging block 125 is significantly smaller in all dimensional respects than a conventional silicon interposer that is typically used in a 2.5D assembly, and which spans all of the chips of the assembly. In contrast, the bridging block 125 of the present disclosure provides contact between the IC chips 105 and 110 by merely overlapping the edges of the IC chips 105 and 110 and making contact with the bridging block contacts 120a, 120b that are located adjacent the edge of each of the IC chips 105 and 110. As generally seen from FIG. 1, the packaging substrate contacts 115a, 115b, which may be bond pads on which either copper pillars solder bumps are formed thereon, are significantly larger than the bridging block contacts 120a, 120b and are exposed such that they can be used to bond the packaging sub-assembly 100 to another packaging substrate. Thus, the significantly smaller bridging block 125 allows interconnection between the IC chips 105 and 110 without interfering with the bonding process that bonds packaging assemblies together.

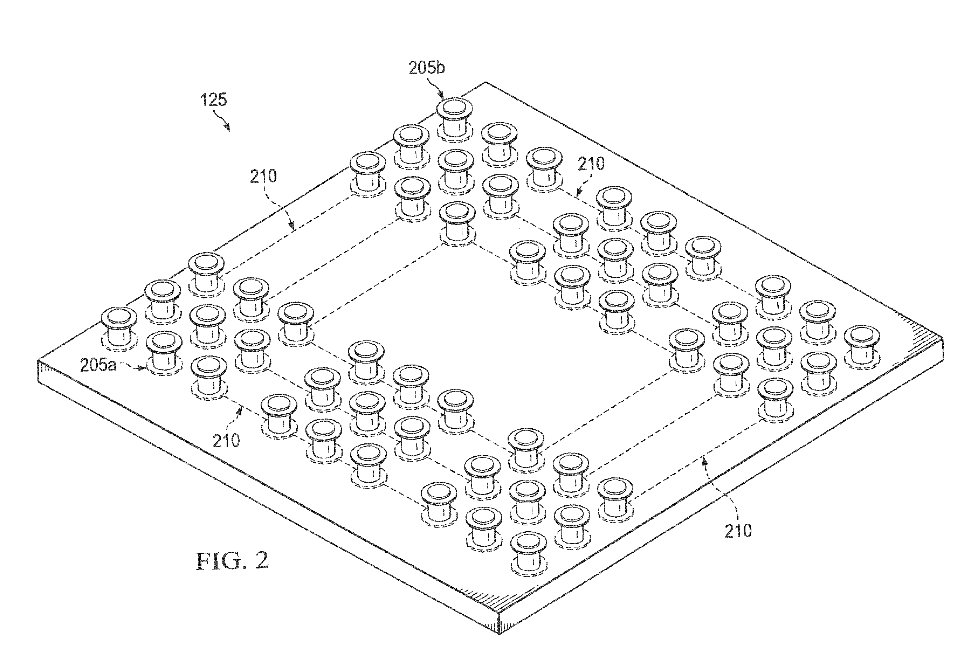

FIG. 2 schematically illustrates an embodiment of the bridging block 125 of FIG. 1. As seen in this embodiment, the bridging block 125 includes interconnected electrical contacts 205a, 205b located on opposing ends of the bridging block 125, which are interconnected by traces or runners 210. The electrical contacts may be bond pads on which solder bumps may be formed, or they may be copper contact pillars, or may include solder bumps located on the bond pads, or other similar known bonding structures. In those embodiments where the bridging block contacts 120a, 120b of IC chips 105 and 110 have high density contacts, the electrical contacts 205a, 205b will also be high density contacts, such that they can correspondingly match with the high density contacts of IC chips 105 and 110. Additionally, in certain embodiments, they will have the same pitch as the bridging block contacts 120a, 120b, as noted above. The bridging contacts 120a, 120b of IC chips 105 and 110 and the electrical contacts 205a, 205b of bridging block 125 provide for a high capacity data flow between the IC chips 105 and 110.

The bridging block 125 may be comprised of silicon or other materials used in semiconductor or semiconductor packaging in which or on which, traces and contacts may be formed. In those embodiments that employ silicon, known thinning silicon processes may be used to fabricate the thin bridging block 125. The bridging block 125 allows it to be used in flip-chip package assemblies without interfering with the bonding of the IC sub-packaging assemblies to form the final IC packaging assembly, while providing a high degree of electrical connectivity between adjacent IC chips 105 and 110. For example, in one embodiment, the thickness of the bridging block is less than about 60 microns. The bridging block 125 serves as a data transfer path between the IC chips 105 and 110, however, in other embodiments, it may include active components, such as memory.

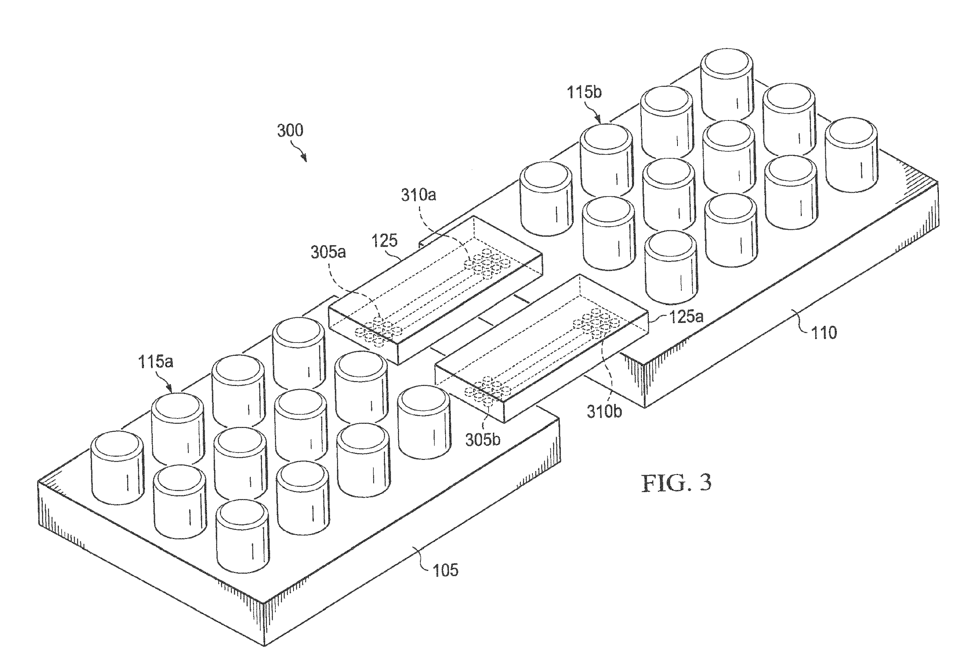

The bridging block 125 is surface mounted to IC chips 105 and 110. Further, the bridging block 125 does not employ TSVs, which reduces processing costs and other cost adders. As such, such devices should have a lower cost piece part compared to a full interposer used of a 2.5D assembly. As used herein and in the claims, "free of a TSV" means that the bridging block 125 itself to which IC chips 105, 110 are attached does not include a TSV structure.FIG. 3 illustrates another embodiment 300 of the IC sub-packaging assembly 100 of FIG. 1. In this embodiment, the IC packaging sub-assembly 300 includes multiple bridging blocks 125, as described above regarding FIG. 2. In this embodiment, the bridging block contacts 120a, 120b of the IC chips 105 and 110 are divided into at least first and second bridge contact groups 305a, 305b and 310a, 310b, as illustrated. Each of the bridging blocks 125 are electrically connected to a respective group of bridging block contacts 305a, 305b and 310a, 310b, as shown and in the manner as previously described. It should be understood that in other embodiments, additional bridging blocks 125 may be present, and in such embodiments, there would be a corresponding number of bridging block contacts 305a, 305b, and 310a, 310b present on each of the IC chips 105 and 110 to which the additional bridging blocks 125 could be connected. The additional bridging blocks 125 provide additional connectivity between the IC chips 105 and 110 to improve data transfer between them.

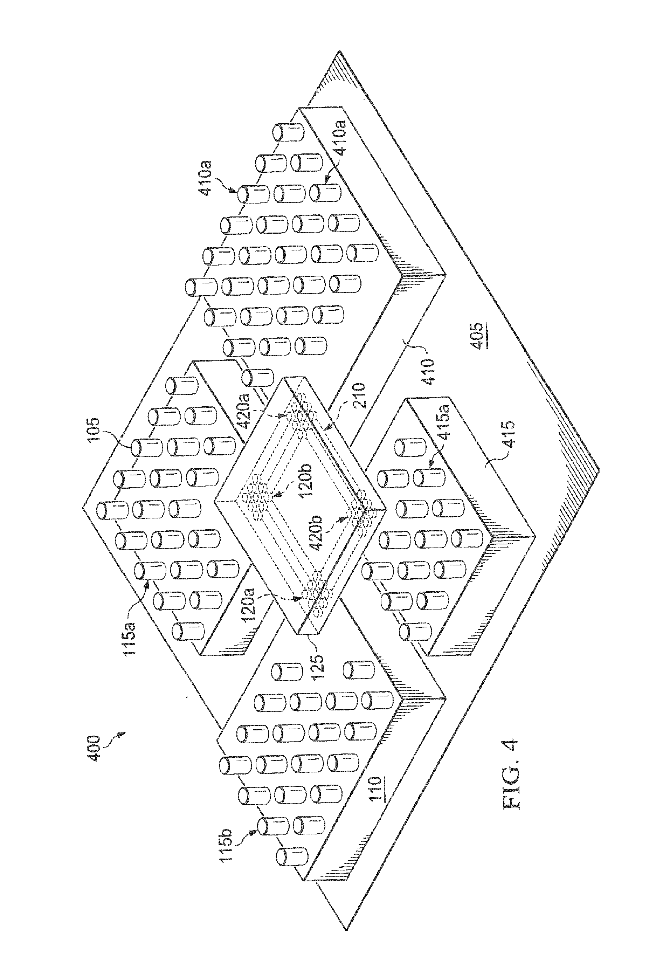

FIG. 4 illustrates another embodiment of an IC packaging assembly 400, wherein an alternative embodiment of the sub-packaging assembly 100 of FIG. 1 is bonded to another conventional sub-packaging substrate 405 to form the packaging assembly 400. This embodiment comprises multiple IC chips 105, 110, and 410 415 and one bridging chip 125 that electrically connects the multiple chips, in a way, as previously discussed with respect to other embodiments. Though the illustrated embodiment 400 shows four IC chips 105, 110, 410 and 415, other embodiments include configurations of three, or more than four IC chips. The additional IC chips 410 and 415 that are electrically connected by the bridging chip 125 each have respective packaging substrate contacts 410a, 415a and bridging block contacts 220a, 220b, as discussed with respect to previous embodiments. As with previous embodiments, the bridging block 125 partially overlaps the IC chips 105, 110, 410 and 415, as shown. In this embodiment, the electrical contacts 205a, 205b of the bridging block 125 (FIG. 2) are divided into the same number of groups as IC chips 105, 110, 410 and 415 being connected together. For example, if three IC chips are being connected together, then the electrical contacts 205a, 205b, which are interconnected by traces or runners 210, will be divided in first, second, and third groups, and if four IC chips are to be interconnected, then four groups will be present, as illustrated, etc. The properties and configuration of all of the contacts discussed with respect to this embodiment are the same as those previously discussed regarding other embodiments. Further, embodiments that include additional bridging chips, as discussed above, could also be used, if so desired.

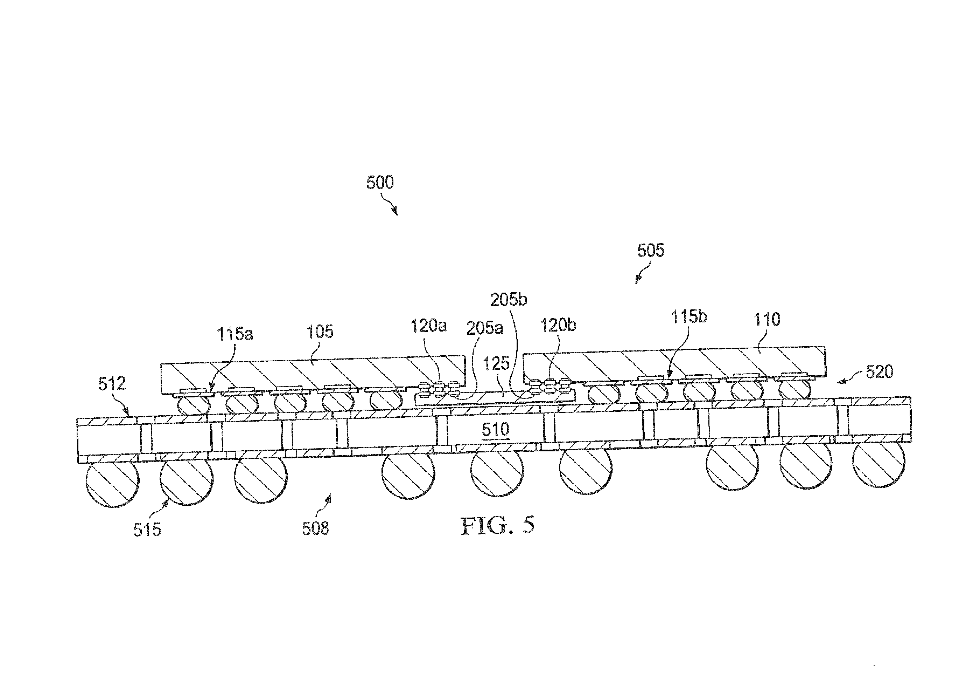

FIG. 5 illustrates one embodiment of an integrated circuit (IC) multi-chip packaging assembly 500. This embodiment includes the IC packaging assembly 100 of FIG. 1, which in this embodiment, is a first sub-packaging assembly 505. It should be understood that any of the embodiments discussed above may be included in the embodiment of FIG. 5. Since the packaging assembly 100 and its various embodiments are discussed above, no further discussion of them will be undertaken here. The assembly 500, however, further includes a second sub-packaging assembly 508 that has a second substrate 510 that includes bond pads 512 and underside interconnects 515.

As seen in FIG. 5, the first sub-packaging assembly 505 is bonded to the bond pads 512 of the second sub-packaging assembly 508 by way of bonding contacts 520, which in the illustrated embodiment are solder bumps, but could also be copper pillars in other embodiments. The bridging block 125 has a thickness that is less than a thickness of the bonding contacts 520, and thus it does not interfere with the process of bonding the two sub-packaging assemblies 505 and 515 together. As such, inter-chip connectivity is achieved, while maintaining a lower profile and without the need for interposers or TSV to interconnect the IC chips 105 and 110 together.

A method of manufacturing is evident from the structures shown in FIGs. 1-5, which can be constructed using conventional manufacturing and assembly processes. It should be understood that the method of fabrication as set forth therein is for illustrative purposes only. Thus, the present disclosure is not limited to just the method discussed herein.

With reference to FIGs. 1-5, the method of manufacturing an integrated circuit (IC) multi-chip sub-packaging assembly 100, comprises obtaining first and second IC chips 105, 110, each having packaging substrate contacts 115a, 115b and bridging block contacts 120a, 120b. As used herein and in the claims "obtaining" means either internally manufacturing the device or acquiring it from a supplier source. A bridging block 125 is also obtained. The bridging block 125 comprises interconnected first electrical contacts 205a located on one end thereof and second electrical contacts 205b located on an opposing, second end thereof. The first electrical contacts 205a of the bridging block 125 are bonded to the bridging block contacts 115a of the first IC chip 105, and the second electrical contacts 205b of the bridging block 125 are bonded to the bridging block contacts 115a of the second IC chip 110. Conventional bonding process, such as solder bump or copper pillar bonding processes may be used to form the bonds. Once the bridging block 125 is electrically connected to the IC chips 105 and 110, it forms a data transfer path between the IC chip 105 and 110.

In another embodiment, the method may further comprise obtaining at least a third IC chip 410 having packaging substrate contacts 410a and bridging block contacts 220a. Further, the process of bonding further comprises bonding the electrical contacts 205a, 205b of the bridging block 125 to the bridging block contacts 220a, 220b of the at least third IC chip 410.

In another embodiment, the bridge contacts 120a, 120b of each of the first and second IC chips 105, 110 are divided into at least first and second bridge contact groups 305a, 305b and 310a and 310b, respectively. In this embodiment, the step of bonding further comprises bonding electrical contacts of a second bridging block 125a to the second bridge contacts 305b, 310b of the first and second IC chips 105, 110.

The bridging block contacts 120a, 120b of the first and second IC chips 105, 110 and the electrical contacts 205a, 205b of the bridging block 125 may be high density contacts having at least about 100 contacts/mm².

In another embodiment, the method may further include bonding the IC multi-chip packaging assembly 505 to a second IC packaging assembly 508. In such embodiments, a second substrate 510 has bond pads 512 wherein the packaging substrate contacts 115a, 115b of the first and second IC chips 105, 110 are connected to the bond pads 512 of the second sub-packaging assembly 508 by bonding contacts 520. The bridging block 125 is located between the first and second packaging assemblies and has a thickness that is less than a thickness of the bonding contacts 520.

Those skilled in the art to which this application relates will appreciate that other and further additions, deletions, substitutions and modifications may be made to the described embodiments.

## Claims

1. An integrated circuit (IC) multi-chip packaging assembly, comprising:
a first IC chip having packaging substrate contacts and bridging block contacts;
a second IC chip having packaging substrate contacts and bridging block contacts; and
a bridging block partially overlapping said first and second IC chips and having interconnected electrical contacts on opposing ends thereof that contact said bridging block contacts of said first IC chip and said second IC chip to thereby electrically connect said first IC chip to said second chip.

2. The IC multi-chip packaging assembly of Claim 1, further comprising a third IC chip having packaging substrate contacts and bridging block contacts, wherein said bridging block further partially overlaps said third IC chip, said electrical contacts of said bridging block being divided into at least first, second, and third groups, and wherein said first group contacts said bridging block contacts of said first IC chip, said second group contacts said bridging block contacts of said second IC chip, and said third group contacts said bridging block contacts of said third IC chip to thereby electrically connect said third IC chip to said first and second IC chips.

3. The IC multi-chip packaging assembly of Claim 1, wherein said bridge contacts of each of said first and second IC chips are divided into at least first and second bridge contact groups and said bridging block is a first bridging block electrically connected to said first bridge contact groups of said first and second IC chips, and said IC multi-chip packaging assembly further comprising at least a second bridging block partially overlapping said first and second IC chips and having electrical contacts on opposing ends thereof that contact said second bridge contact groups of said first and second IC chips.

4. The IC multi-chip packaging assembly of Claim 1, wherein said bridging block contacts of said first and second IC chips and said electrical contacts of said bridging block are high density contacts.

5. The IC multi-chip packaging assembly of Claim 1, wherein said bridging block provides a data transfer path between said first IC chip and said second IC chip.

6. An integrated circuit (IC) multi-chip packaging assembly, comprising:
a first sub-packaging assembly, comprising:
a first IC chip having packaging substrate contacts and bridging block contacts;
a second IC chip having packaging substrate contacts and bridging block contacts; and
a bridging block partially overlapping said first and second IC chips and having interconnected electrical contacts on opposing ends thereof that contact said bridging block contacts of said first IC chip and said second IC chip to thereby electrically connect said first IC chip to said second chip; and
a second sub-packaging assembly, comprising:
a second substrate having bond pads wherein said packaging substrate contacts of said first and second IC chips are connected to said bond pads of said second sub-packaging assembly by bonding contacts, said bridging block having a thickness that is less than a thickness of said bonding contacts and located between said first and second sub-packaging assemblies.

7. The IC multi-chip packaging assembly of Claim 6, wherein said electrical connection structure comprises solder bumps or copper pillars.

8. The IC multi-chip packaging assembly of Claim 6, wherein said first sub-packaging assembly further comprises a third IC chip having packaging substrate contacts and bridging block contacts, wherein said bridging block further partially overlaps said third IC chip, said electrical contacts of said bridging block being divided into at least first, second, and third groups, and wherein said first group contacts said bridging block contacts of said first IC chip, said second group contacts said bridging block contacts of said second IC chip, and said third group contacts said bridging block contacts of said third IC chip to thereby electrically connect said third IC chip to said first and second IC chips.

9. The IC multi-chip packaging assembly of Claim 6, wherein said bridge contacts of each of said first and second IC chips are divided into at least first and second bridge contact groups and said bridging block is a first bridging block electrically connected to said first bridge contact groups of said first and second IC chips, and said first IC multi-chip packaging assembly further comprising at least a second bridging block partially overlapping said first and second IC chips and having electrical contacts on opposing ends thereof that contact said second bridge contact groups of said first and second IC chips.

10. The IC multi-chip packaging assembly of Claim 6, wherein said bridging block is free of through silicon vias (TSV).
